# EUROPEAN PATENT APPLICATION

(11) **EP 0 828 014 A2**
(43) Date of publication of application: **11.03.1998**
(21) Application number: 97115265.7
(22) Date of filing: 03.09.1997
(51) Int. Cl.: C23C 16/26, C23C 30/00, B26B 19/00

(54) **Hard carbon film**

(30) Priority: 06.09.1996 JP 236802/96
(71) Applicant: SANYO ELECTRIC Co., Ltd., Moriguchi-shi, Osaka (JP)
(72) Inventor: Hirano, Hitoshi, Nishinomiya-city, Hyogo, 663 (JP); Domoto, Yoichi, Ikoma-city, Nara, 630-01 (JP); Kuramoto, Keiichi, Kadoma-city, Osaka 571 (JP); Tarui, Hisaki, Sijyounawate-city, Osaka 575 (JP); Kiyama, Seiichi, Takatsuki-city, Osaka 569-11 (JP)
(74) Representative: TER MEER STEINMEISTER & PARTNER GbR

(57) **Abstract**

A hard carbon film for provision on a substrate is disclosed which has a coefficient of visible light absorption not greater than 1 x 10⁵ cm⁻¹, and a color tone of which is controllable by a thickness of the hard carbon film.

## Description

### BACKGROUND OF THE INVENTION

### FILED OF THE INVENTION

The present invention relates to a hard carbon film for use as a protective film such as on inner and outer blades for an electric shaver, magneto-optical disks, thin film magnetic heads and sliding surfaces of compressors; an antireflection film utilized during exposure in a lithography method; a coating film such as on constituent layers of solar batteries, decorative articles, optical parts; or a surface coating film.

### DESCRIPTION OF RELATED ART

The hard carbon film has gained great expectations of its capability to serve as a coating material for modifying surfaces of a substrate since it exhibits excellent hardness, resistivity, chemical stability and others as comparable to those of diamond.

For the purpose of improving adhesion of the hard carbon film to the substrate, a plasma CVD method has been conventionally employed to form on a substrate an interlayer comprised principally of silicone on which the hard carbon film is formed, such as disclosed in Japanese Patent Laying-Open No. Hei 1-317197 (1989).

Japanese Patent Laying-Open No. Hei 2-133573 (1990) proposes to impose a negative self-bias voltage across a substrate in the plasma CVD method to form on the substrate a hard carbon film which exhibits an increased film hardness.

However, in an illustrative case where the hard carbon film is applied onto an electric shaver outer blade to serve as its protective coating, the resulting hard carbon film exhibits color tones disadvantageously varied with employed fabrication conditions and the others. It has been accordingly difficult to fabricate the electric shaver outer blade having a desired color tone.

It is therefore an object of the present invention to provide a hard carbon film controlled to a predetermined color tone and a method for forming the same.

### SUMMARY OF THE INVENTION

The present invention provides a hard carbon film for provision on a substrate, which is characterized by having a coefficient of visible light absorption not greater than 1 x 10⁵ cm⁻¹ and a color tone controlled by a thickness of the hard carbon film.

The present invention further provides a hard carbon film for provision on a substrate, which is characterized by having a coefficient of visible light absorption not greater than 1 x 10⁻⁵ cm⁻¹ and a Vickers hardness of at least 2000 Hv.

In the hard carbon film of the present invention, the coefficient of its visible light absorption is controllable by regulating a self-bias voltage produced in said substrate during formation of the hard carbon film.

Also, the hardness of the hard carbon film is controllable by regulating a self-bias voltage produced in said substrate during formation of the hard carbon film.

The self-bias voltage produced in the substrate is controllable by regulating a RF voltage to be supplied to the substrate from a high-frequency power source.

In the present invention, the color tone of the hard carbon film is controllable by varying a thickness of the hard carbon film.

In preferred embodiments in accordance with the present invention, an interlayer is formed between the substrate and the hard carbon film. The provision of such an interlayer improves adhesion between the substrate and the hard carbon film. The thickness of the interlayer is preferable in the range of 50Å-8000Å. The preferred materials for the interlayer include Si, Zr, Ti, Ru and Ge, oxides, nitrides and carbides thereof.

In preferred embodiments in accordance with the present invention, the interlayer comprises oxides, nitrides or carbides of Si, Zr, Ti, Ru or Ge and has a content gradient of oxygen, nitrogen or carbon in its thickness direction. It is preferred that the content gradient of oxygen, nitrogen or carbon in the interlayer is greater in its thickness portion remoter from the substrate.

In the present invention, it is preferred that the thickness of the hard carbon film is in the range of 50Å-5000Å.

The hard carbon film in accordance with the present invention is preferably formed by a plasma CVD method.

In the present invention, the hard carbon film is an amorphous diamond-like carbon film, a diamond-like carbon film containing crystalline portions or a crystalline film, for example.

A member in accordance with the present invention includes a substrate and the above hard carbon film of the present invention which is directly or indirectly provided on the substrate.

The member of the present invention is an outer or inner blade for an electric shaver, for example. The present invention is also applicable to a protective film for magneto-optical disks, thin film magnetic heads and sliding surfaces of compressors; an antireflection film utilized during exposure in a lithography method; a coating film such as on constituent layers of solar batteries, decorative articles, optical parts; and a surface coating film.

A method for forming a hard carbon film, in accordance with the present invention, comprises the steps of regulating a self-bias voltage produced in a substrate such that a coefficient of visible light absorption of the hard carbon film to be formed is not greater than 1 x 10⁵ cm⁻¹ and forming on the substrate the hard carbon film to such a thickness that a predetermined color tone is given to the hard carbon film.

A general method of producing the self-bias voltage in the substrate is supplying a RF voltage from a high-frequency power source to the substrate. The self-bias voltage produced in the substrate can be controlled by regulating the RF voltage.

### BRIEF DESCRIPTION OF THE DRAWINGS

Figure 1 is a schematic block diagram of an exemplary apparatus for forming a hard carbon film in accordance with the present invention;
Figure 2 is a perspective view showing a reaction gas inlet line of the apparatus of Figure 1 and its vicinities;
Figure 3 is a graph showing a relation between a hardness of a resulting diamond-like carbon film and a self-bias voltage produced in a substrate as the self-bias voltage was varied;
Figure 4 is a graph showing a relation between the hardness of the resulting diamond-like carbon film and a coefficient of its visible light absorption;
Figure 5 are graphs showing relations between the visible light absorption coefficients of the resulting diamond-like carbon films and wavelengths at varied self-bias voltages produced in the substrate;
Figure 6 is a graph showing a relation between a film-forming period and a CH₄ feed rate when an interlayer having a content gradient in its thickness direction was formed in accordance with one embodiment of the present invention; and
Figure 7 is a graph showing a relation between the film-forming period and a supplied power when the interlayer having the content gradient in its thickness direction was formed in accordance with one embodiment of the present invention.

### DESCRIPTION OF THE PREFERRED EMBODIMENTS

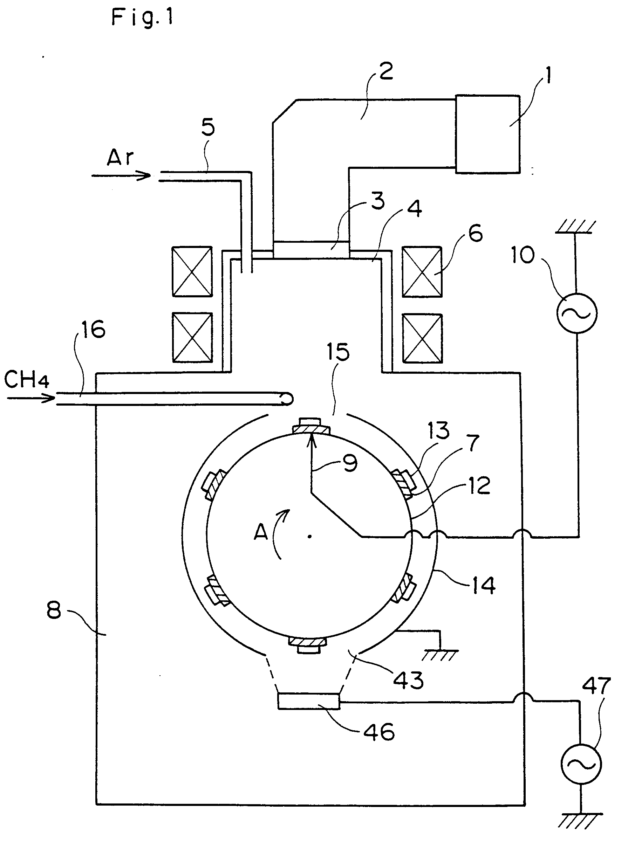

Figure 1 is a schematic block diagram of an exemplary apparatus for forming a hard carbon film.

Referring to Figure 1, disposed interior of a vacuum chamber 8 is a plasma generation chamber 4 to which one end of a waveguide 2 is connected. The waveguide 2 has another end to mount a microwave supplying means 1.

The microwaves generated within the microwave supplying means 1 are guided to pass through the waveguide 2 and a microwave inlet window 3 into the plasma generation chamber 4. Connected to the plasma generation chamber 4 is a discharge gas inlet line 5 for introducing a discharge gas such as argon (Ar) gas into the plasma generation chamber 4.

A plurality of plasma magnetic field generators 6 is mounted circumferentially of the plasma generation chamber 4. A high-density plasma can be produced within the plasma generation chamber 4 by influencing a high-frequency magnetic field produced by the microwaves upon the magnetic field generated by the plasma magnetic field generators 6.

A drum-shaped substrate holder 12 is disposed within the vacuum chamber 8 so as to be rotatable about an axis (not shown) which arranged perpendicularly to a wall surface of the vacuum chamber 8. A number of substrates 13 is arranged circumferentially of the substrate holder 12 at regular intervals.

In this particular embodiment, a Ni outer blade for an electric shaver is used as the substrate 13, and twenty four of the Ni outer blade are mounted circumferentially of the substrate holder 12.

A brush 9 fixed to the vacuum chamber 8 by suitable means is arranged at the substrate holder 12 such that an electrode 7 is brought into a sliding contact with the brush 9 when it moves with the rotating substrate holder 12 to reach a position facing toward the plasma generation chamber 4. The brush is connected to a first high-frequency power source 10.

Accordingly, as the substrate holder 12 rotates, the electrode 7 moves to the position for sliding contact with the brush 9 through which a RF voltage from the first high-frequency power source 10 is applied to the electrode 7.

A hollow cylindrical shielding cover 14, made of metal, radially surrounds the substrate holder 12 to define therebetween a predetermined spacing. The shielding cover 14 is connected to a grounded electrode. The shielding cover 14 functions to prevent generation of discharges between the vacuum chamber 8 and the substrate holder 12 excluding target film-forming locations thereon, which discharges will be otherwise generated when a radio frequency (also referred to as RF) voltage is applied to the substrate holder 12 for film-forming.

The spacing between the substrate holder 12 and the shielding cover 14 may be dimensioned to be smaller than a mean free path of gaseous molecules. The mean free path of gaseous molecules is equal to or smaller than the average distance that ions or electrons accelerated by an electric field can travel without collisions.

Thus, the probability of collisions between the gaseous molecules and the ions or electrons can be lowered to thereby prevent the molecules from undergoing chain electrolytic dissociations by dimensioning the spacing between the substrate holder 12 and the shielding cover 14 not to exceed the mean free path of the gaseous molecules.

It is preferred that the spacing between the substrate holder 12 and the shielding cover 14 is dimensioned not to exceed one tenth of the mean free path of the gaseous molecules. In this particular embodiment of the apparatus, the spacing between the substrate holder 12 and the shielding cover 14 is dimensioned to be about 5 mm so as not to exceed one tenth of the mean free path of the gaseous molecules.

The shielding cover 14 has at its top a first opening 15. A plasma from the plasma generation chamber 4 is directed to pass through the first opening 15 to impact the substrates 13 mounted on the substrate holder 12.

The vacuum chamber 8 is equipped with a reaction gas inlet line 16. A leading end of the reaction gas inlet line 16 is positioned above the first opening 15.

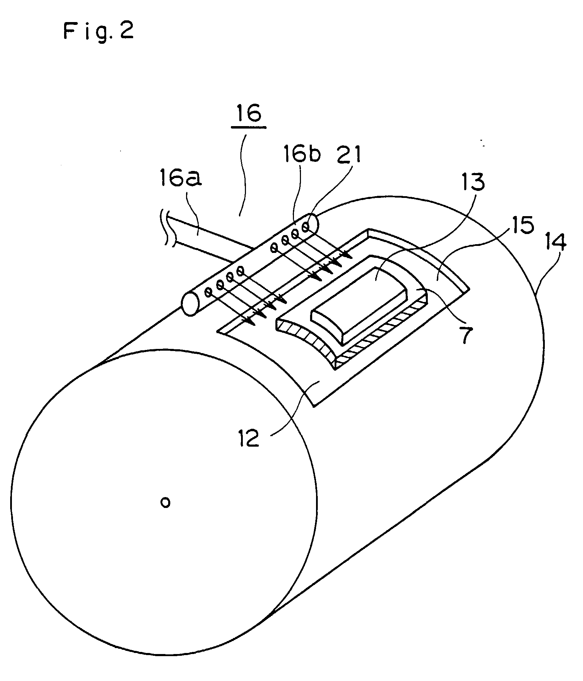

Figure 2 is a perspective view showing the leading end of the reaction gas inlet line 16 and its vicinities.

Referring to Figure 2, the reaction gas inlet line 16 includes a gas inlet portion 16a for introducing a CH₄ gas into the vacuum chamber 8 and a gas discharge portion 16b for perpendicular connection to the gas inlet portion 16a.

The gas discharge portion 16b is arranged to perpendicularly cross a rotational direction A of the substrate holder 12 and is positioned above the first opening 15. In the plan view, the gas discharge portion 16b is located upstream along the direction A within the first opening 15. The gas discharge portion 16b has a plurality of holes 21 which is directed downwardly each at an angle of about 45 degrees.

In this particular embodiment, the gas discharge portion 16b has eight holes 21, as shown in Figure 2. These holes 21 are spaced from each other at distances which become smaller toward each end of the gas discharge portion 16b. The provision of the holes 21 at such spacings allows the CH₄ gas introduced from the gas inlet portion 16a to be discharged therefrom with a substantially uniform distribution along the length of the gas discharge portion 16b.

Referring back to Figure 1, the shielding cover 14 has at its bottom a second opening 43 which vertically faces the first opening 15. A target 46 is disposed below the second opening 43 so as to upwardly face the second opening 43.

Connected to the target 46 is a second high-frequency power 47 which applies the RF voltage to the target 46.

Examples are now given which utilize a single element to form an interlayer on which a diamond-like carbon film is further formed.

The vacuum chamber 8 is first evacuated to a pressure of 10⁻⁵-10⁻⁷ Torr. , followed by rotation of the substrate holder 12 at a speed of about 10 rpm. The Ar gas at 1.5 x 10⁻³ Torr. is supplied through the discharge gas inlet line 5 while a 13.56 MHz RF voltage from the second high-frequency power source 47 is applied to the Si target 46. Here, the power supplied to the target 46 was set at 200 W, and the self-bias voltage produced in the substrate 13 was set at - 50 V.

The above process was continued for about 30 minutes. As a result, an Si interlayer was formed on a surface of the substrate 13 to a thickness of 0.05 µm.

The RF voltage application by the second high-frequency power source 47 was then discontinued. Subsequently, the Ar gas at 5.7 x 10⁻⁴ torr. was supplied from the discharge gas inlet line 5 of the ECR plasma generation apparatus while a 2.45 GHz, 100 W microwave is supplied from the microwave supplying means 1, so that an Ar plasma is generated within the plasma generation chamber 4 to strike a surface of each substrate 13. Simultaneously with this step, a CH₄ gas at 1.3 x 10⁻³ Torr. was supplied through the reaction gas inlet line 16 while a 13.56 MHz RF power from the first high-frequency power source 10 was supplied to the substrate holder 12 such that the self-bias voltage of -50 V was generated in the substrate 13.

The above step was continued for about 15 minutes. As a result, a diamond-like carbon film was formed on the interlayer overlying the substrate 13 to a thickness of 1000Å.

The term "hard carbon film" , as used herein, is intended to include an amorphous diamond-like carbon film, a diamond-like carbon film containing crystalline portions and a crystalline film.

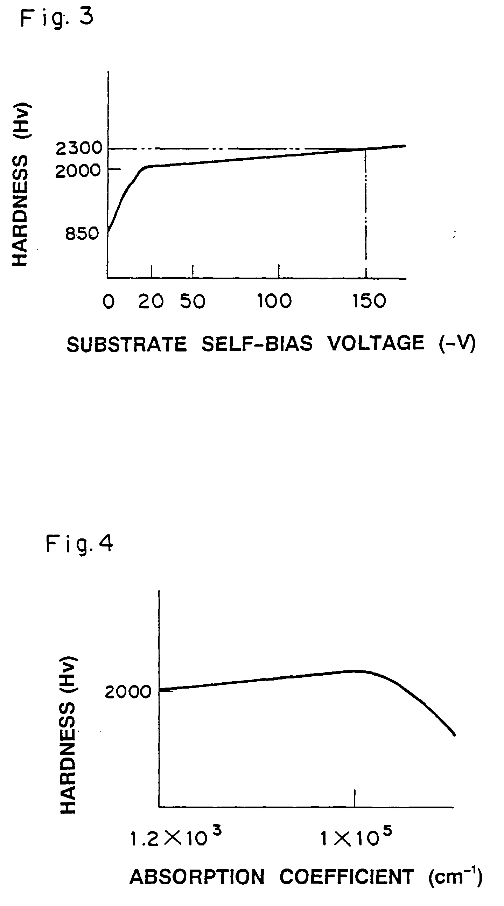

The self-bias voltage produced in the substrate 13 was varied to form the interlayers and the diamond-like carbon films on respective interlayers at -20 V, -100 V and -150 V. The relation between the hardnesses of the resulting diamond-like carbon films and the self-bias voltages produced in the substrate is shown in Figure 3.

As apparent from Figure 3, the hardness of the resulting diamond-like carbon film rapidly increases until the self-bias voltage reaches -20 V, and gradually increases as the self-bias voltage changes from -20 V to -150 V.

The diamond-like carbon films as obtained above were evaluated for their levels of adhesion. The adhesion evaluation was made by an indentation test in which a Vickers indenter was forced under a constant load (Load = 1 kg) into film surfaces. Fifty samples were taken for each diamond-like carbon film-coated Ni substrate, and the number of samples which showed delamination of the diamond-like carbon film was counted as being indicative of a level of adhesion of the hard carbon film. Results are given in Table 1.

As apparent from Table 1, the diamond-like carbon film-coated Ni substrates which were formed at the substrate self-bias voltage of at least -20 V experienced no delamination of their diamond-like carbon films.

**Table 1**

| | | | | | | |
|---|---|---|---|---|---|---|
| Self-Bias Voltage | 0V | -20V | -50V | -100V | -150V | -500V |
| Number of *Samples | 5 | 0 | 0 | 0 | 0 | 0 |

| | | | | | | |
|---|---|---|---|---|---|---|
| *Samples which experienced delamination of the diamond-like film | | | | | | |

Figure 4 shows a relation between the hardness of the resulting diamond-like carbon film and its coefficient of visible light absorption.

As can be clearly seen from Table 1, the Vickers hardness of the diamond-like carbon film exhibits 2000 Hv while it has the absorption coefficient of 1.2 x 10³ cm⁻¹, gradually increases until its absorption coefficient reaches 1 x 10⁵ cm⁻¹, amounts to 2300 Hv as its absorption coefficient reaches 1 x 10⁵ cm⁻¹, and rapidly increases as its absorption coefficient goes beyond 1 x 10⁵ cm⁻¹.

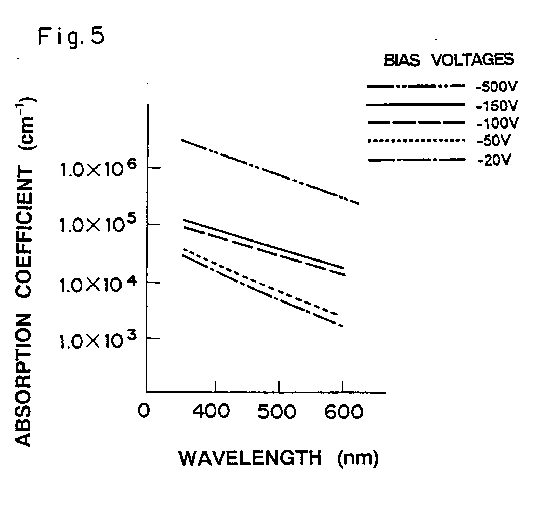

Figure 5 shows a relation between the coefficient of visible light absorption and the wavelength of the diamond-like carbon film, at each of the varied self-bias voltages produced in the substrate.

As can be seen from Figure 5, the absorption coefficient relates linearly to the wavelength. As will be now appreciated, the absorption coefficient of the diamond-like carbon film provided on the substrate can be changed in a controlled fashion by varying the self-bias voltage which is generated in the substrate for providing the diamond-like carbon film thereon.

It is difficult to control the color tone of the diamond-like carbon film as it is excessively thinner. On the other hand, the transmittance is disadvantageously reduced as the diamond-like carbon film gets thicker. It is therefore preferred that the thickness of the interlayer is in the range of 50Å-8000Å while that of the diamond-like carbon film is in the range of 50Å-3000Å. More preferably, the thicknesses of the interlayer and the diamond-like carbon film are in the ranges of 50Å-2000Å and 50Å-2000Å, respectively.

Since the color tone of the diamond-like thin film is produced by interference of light, it changes with the thickness of the thin film. Accordingly, in this particular embodiments, as the thickness of the diamond-like carbon film is gradually increased, its color tone cyclically changes in the order of "yellow", "red", "purple", "blue", "blue-green", "green" and "yellow", ···. In an exemplary case where an electric shaver outer blade comprised of Ni is used as the substrate and an Si interlayer is formed thereon to a thickness of 0.05 µm, the color tone can be changed to move one cycle, i.e. starting from a specific color and returning to the specific color by varying the thickness of the diamond-like carbon film formed on the interlayer within the range of 300Å-2000Å.

An example will be now given which utilizes a material atom of a substrate and carbon to form a mixed layer, i.e. an interlayer on which a diamond-like carbon film is formed. An apparatus as analogous to the apparatus of Figure 1 was employed in this example.

First, twenty four of the substrates 13 were mounted to the substrate holder 12 for arrangement circumferentially thereof at regular intervals. The vacuum chamber 8 was evacuated to a pressure of 10⁻⁵-10⁻⁷ Torr. , followed by rotation of the substrate holder 12 at a speed of about 10 rpm.

An Ar gas at 1.5 x 10⁻³ torr. was then supplied from the discharge gas inlet line 5 while a 2.45 GHz, 100 W microwave was supplied from the microwave supplying means 1, so that an Ar plasma was generated within the plasma generation chamber 4 to strike a surface of each substrate 13.

Simultaneously with this step, a 13.56 MHz RF voltage from the first high-frequency power source 10 was applied to the brush 9 so that a self-bias voltage of -50 V was generated in the substrate 13 on the electrode 7 when it was brought into a sliding contact with the brush 9.

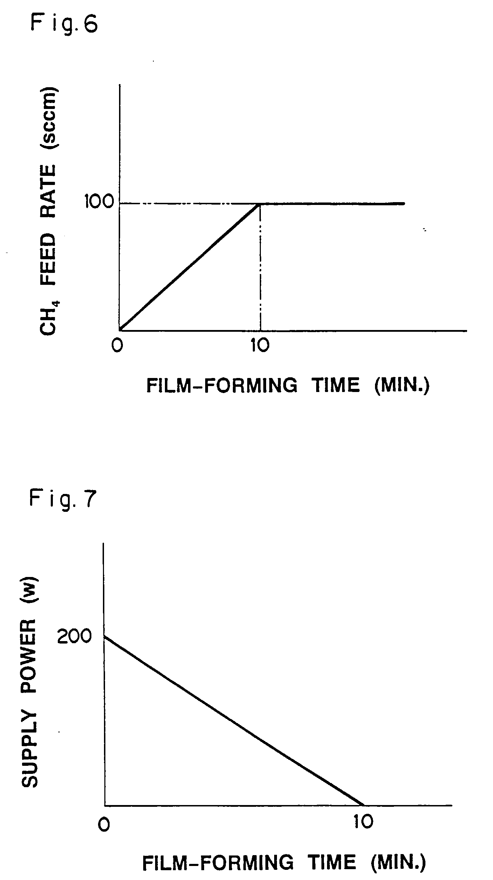

At the same time, a CH₄ gas was supplied through the reaction gas inlet line 16. The CH₄ gas supply was linearly increased in a controlled fashion, as shown in Figure 6, so that it reached 100 sccm, i.e. 1.3 x 10⁻³ torr. in 10 minutes from the start.

In this example, the interlayer was formed by a high-frequency sputtering apparatus while the thin film formation was performed by the ECR plasma CVD apparatus.

More specifically, a 13.56 MHz RF voltage from the second high-frequency power source 47 was applied to the Si target 46. The RF power was linearly reduced as shown in Figure 7 to reach 0 W in ten minutes from the start. Also, the self-bias voltage generated in the substrate 13 was controlled at -50 V, as described above.

The above step was continued for about 30 minutes. As a result, the interlayer, i.e. the Si-C mixed layer was formed on a surface of the substrate to a thickness of 0.05 µm.

As shown in Figures 6 and 7, the Si content in the resulting interlayer was reduced with time while the C content was increased. As a result, a content gradient was produced in a thickness direction of the interlayer such that a thickness portion of the interlayer remoter from the surface of the substrate 13 had a lower Si content and a higher C content.

A diamond-like carbon film was then formed on the interlayer as thus formed. The partial pressure of the CH₄ gas from the reaction gas inlet line 16 was maintained constant at 1.3 x 10⁻³ torr., and the thin film formation was succeeded using the above ECR plasma generation apparatus. This step was continued for about 15 minutes to form the diamond-like carbon film on the interlayer overlying the substrate 13 to a thickness of 1200Å.

As a result, the Si-C interlayer having the above-described content gradient and the diamond-like carbon film were laminated on the substrate 13 to form a multi-layer film thereon. The interlayer having such a content gradient provides improved adhesion between the substrate 13 and the diamond-like carbon film relative to the above interlayer comprised of a single element.

An example will be given below which forms interlayers principally of Si on respective Ni substrates to varied thicknesses and subsequently forms a diamond-like carbon film on each of the interlayers.

The vacuum chamber 8 is first evacuated to a pressure of 10⁻⁵-10⁻⁷ Torr. , followed by rotation of the substrate holder 12 at a speed of about 10 rpm. An Ar gas was supplied to an ion gun 47 from which Ar ions were directed to a surface of the Si target 46.

The acceleration voltage and current density of the Ar ions were controlled at 900 eV and 0.4 mA/cm², respectively. The deposition rate of Si when sputtered onto the substrate was 30 Å/min.

The process time of Si sputtering was varied to form Si interlayers having thicknesses of 30Å, 50Å, 100Å, 500Å, 1000Å, 2000Å, 4000Å, 6000Å and 8000Å (EXAMPLE 1).

A diamond-like carbon film was formed on each of the above-formed interlayers having different thicknesses to a thickness of 1200Å, as analogously to the above example.

Each of the above-formed diamond-like carbon films was evaluated for its adhesion to the Ni substrate, in the same manner as described above. For comparative purposes, a diamond-like carbon film was formed directly on the Ni substrate without interposition of the interlayer therebetween (COMPARATIVE EXAMPLE 1). This comparative diamond-like carbon film was also evaluated for its adhesion to the Ni substrate.

Results are given in Table 2.

**Table 2**

| | Comp. Exp. | Example 1 | | | |
|---|---|---|---|---|---|
| | | 30Å | 50Å | 100Å | 500Å |
| Number of *Samples | 43 | 16 | 0 | 0 | 0 |
| | | | | | |

| | Example 1 | | | | |
|---|---|---|---|---|---|
| | 1000Å | 2000Å | 4000Å | 6000Å | 8000Å |
| Number of *Samples | 0 | 0 | 0 | 0 | 0 |

| | | | | | |
|---|---|---|---|---|---|
| *Samples which experienced delamination of the diamond-like film | | | | | |

As can be seen from Table 2, no diamond-like carbon film experienced delamintation from the Ni substrate if the underlying interlayer had a thickness of at least 50Å. However, the delamination was recognized for the diamond-like carbon film overlying the interlayer having a thickness below 50Å.

The following example describes the formation of Si-C mixed layers having varied thicknesses. The Si-C mixed layers were formed in the same manner as in the above-described example wherein the Si-C mixed layer was formed to serve as the interlayer. Accordingly, each of these mixed layers had the content gradient in its thickness direction. The thickness of the interlayer, i.e. the Si-C mixed layer was varied in the range of 30Å, 50Å, 100Å, 500Å, 1000Å, 2000Å, 4000Å, 6000Å and 8000Å (EXAMPLE 2). A diamond-like carbon film was formed on each of those interlayers to a thickness of 1200Å.

Each of the above-formed diamond-like carbon films was evaluated for its adhesion to the Ni substrate, in the same manner as in Example 1.

Results are given in Table 3.

**Table 3**

| | Comp. Exp. | Example 2 | | | |
|---|---|---|---|---|---|
| | | 30Å | 50Å | 100Å | 500Å |
| Number of *Samples | 43 | 14 | 0 | 0 | 0 |
| | | | | | |

| | Example 2 | | | | |
|---|---|---|---|---|---|
| | 1000Å | 2000Å | 4000Å | 6000Å | 8000Å |
| Number of *Samples | 0 | 0 | 0 | 0 | 0 |

| | | | | | |
|---|---|---|---|---|---|
| *Samples which experienced delamination of the diamond-like film | | | | | |

As apparent from Table 3, no diamond-like carbon film experienced delamintation from the Ni substrate if the underlying interlayer, i.e. the Si-C mixed layer had a thickness of at least 50Å. However, the delamination was recognized for the diamond-like carbon film overlying the interlayer having a thickness below 50Å.

This demonstrates that the preferred thickness of the interlayer is at least 50Å even in the case where the Si-C mixed layer is formed to serve as the interlayer.

Next, a nitrogen gas as a reaction gas containing nitrogen was supplied from the gas inlet line 16 of Figure 1 into the vacuum chamber 8 to form the Si-N mixed layer serving as the interlayer.

The partial pressure of the supplied nitrogen gas was controlled at 1.8 x 10⁻⁴ Torr. The other conditions were adjusted to follow those of Example 2 to form a diamond-like carbon film on the Si-N interlayer. The obtained results were similar to those shown by values in Table 3.

An Si-O mixed layer was then formed which served as the interlayer on which a diamond-like carbon film was formed. An oxygen gas was used as a reaction gas containing oxygen when forming the Si-O mixed layer. The partial pressure of the supplied oxygen gas was controlled at 1.8 x 10⁻⁴ Torr. The other conditions were adjusted to follow those of Example 2 to form a diamond-like carbon film on the Si-O interlayer. The obtained results were similar to those shown by values in Table 3.

Si was then replaced by the other material atoms for the interlayer, i.e. Zr, Ti, Ru and Ge to form a variety of mixed layers on which a diamond-like carbon film was formed.

Each of the resulting diamond-like carbon films was evaluated for its adhesion to the Ni substrate, in the same manner as in Examples 1 and 2. The obtained results showed similarity with those shown in Tables 2 and 3.

In the above embodiments of the present invention, the interlayer was formed by sputtering. Alternatively, the plasma CVD methods may be employed to form the interlayer. In such an instance, the interlayer can be formed on the substrate 13 by supplying a gas containing a material atom of the interlayer from the reaction gas inlet line 16 into the vacuum chamber 8 to form a plasma and directing the formed plasma to the substrate 13.

It should be recognized that an ion beam sputtering method can be also employed to form the interlayer.

Although the ECR plasma generation apparatus was illustrated as a means for generating a plasma in the above embodiments of the present invention, it is not intended to limit the scope of the present invention. The other plasma CVD apparatuses can be employed which include RF plasma CVD and DC arc plasma CVD apparatuses.

As can be appreciated from the above descriptions, in accordance with the present invention, a color tone of a hard carbon film provided on a substrate is controllable to a desired one. Furthermore, a resulting hard carbon film exhibits improved adhesion to the substrate as well as an increased hardness.

## Claims

1. A hard carbon film for provision on a substrate, said hard carbon film having a coefficient of visible light absorption not greater than 1 x 10⁵ cm⁻¹, a color tone of said hard carbon film being controllable by a thickness of said hard carbon film.

2. A hard carbon film for provision on a substrate, said hard carbon film having a coefficient of visible light absorption not greater than 1 x 10⁻⁵ cm⁻¹ and a Vickers hardness of at least 2000 Hv.

3. The hard carbon film of Claim 2, wherein the coefficient of visible light absorption of said hard carbon film is controllable by regulating a self-bias voltage produced in said substrate during formation of the hard carbon film.

4. The hard carbon film of Claim 2 or 3, wherein the color tone of said hard carbon film is controllable by varying the thickness of the hard carbon film.

5. The hard carbon film of any one of Claims 2-4, wherein the hardness of said hard carbon film is controllable by regulating the self-bias voltage produced in said substrate during formation of the hard carbon film.

6. The hard carbon film of any one of Claims 2-5, wherein an interlayer is formed between said substrate and hard carbon film to a thickness of 50Å-8000Å.

7. The hard carbon film of Claim 6, wherein said interlayer comprises at least one material selected from the group consisting of Si, Zr, Ti, Ru and Ge, oxides, nitrides and carbides thereof.

8. The hard carbon film of Claim 7, wherein said interlayer comprises oxides, nitrides or carbides of Si, Zr, Ti, Ru or Ge and has a content gradient of oxygen, nitrogen or carbon in its thickness direction.

9. The hard carbon film of Claim 8, wherein said content gradient of oxygen, nitrogen or carbon in the interlayer is greater in its thickness portion remoter from the substrate.

10. The hard carbon film of any one of Claims 2-9, wherein a thickness of said hard carbon film is in the range of 50Å-5000Å.

11. The hard carbon film of any one of Claims 2-10, wherein said hard carbon film is formed by a plasma CVD method.

12. The hard carbon film of any one of Claims 1-11, wherein said hard carbon film is an amorphous diamond-like carbon film, a diamond-like carbon film containing crystalline portions or a crystalline film.

13. A member including a substrate and the hard carbon film of any one of Claims 1-12 directly or indirectly provided on said substrate.

14. The member of claim 13, wherein said member is an outer or inner blade for an electric shaver.

15. A method for forming on a substrate a hard carbon film controlled to have a predetermined color tone, said method comprising the steps of:
regulating a self-bias voltage produced in said substrate so that a coefficient of visible light absorption of the hard carbon film to be formed is not greater than 1 x 10⁵ cm⁻¹; and
forming on said substrate said hard carbon film to such a thickness that said predetermined color tone is given to the hard carbon film.
